# EUROPEAN PATENT APPLICATION

(11) **EP 2 166 365 A1**
(43) Date of publication of application: **24.03.2010**
(21) Application number: 08290888.0
(22) Date of filing: 19.09.2008
(51) Int. Cl.: G01R 31/327, G01R 31/28, B61L 15/00, H01H 47/00

(54) **Distributed safety monitoring system provided with a safety loop and method of testing such a system**

(71) Applicant: Bombardier Transportation GmbH, 10785 Berlin (DE)
(72) Inventor: Baert, Mike, 8200 Brügge (BE)
(74) Representative: Novagraaf IP

(57) **Abstract**

A distributed safety monitoring system is provided with a first safety loop for connecting safety relays in series to a common power supply. The opening of any one of the safety relays can be detected by a current detector located in the safety loop. Each safety relay is part of a local safety monitoring device, which is provided with a local power supply and a test circuit, to allow local testing of the safety relay independently from the common power supply. Hence, the safety relays can be tested simultaneously.

## Description

### TECHNICAL FIELD OF THE INVENTION

The invention relates to a distributed safety system and more specifically to a safety system provided with a safety loop for connecting distributed safety devices such as vibration monitoring devices in a rail vehicle. The invention also relates to a safety monitoring device for use in such a safety loop and to a method of testing such a system.

### BACKGROUND ART

A vibration monitoring system for a rail vehicle is known from the documents DE 100 20 519, DE 100 20 520 and DE 100 20 521. One or more accelerometers, preferably tri-axial accelerometers, are connected to a central signal processing unit located at a remote location on the train consist. While this type of configuration may prove adapted to the monitoring of specific vehicle subsystems like brakes, bogies or car bodies for diagnostic purposes, it does not provide the level of safety and reliability required for safety components. In particular, the transmission of the acceleration signals from the accelerometers to the remote processing unit may suffer from an insufficient signal to noise ratio. Moreover, the failure of one accelerometer or of the central signal processing unit may remain undetected. The existing attempts to implement an instability detection device are based on sensors (e.g. accelerometers) and a remote software-based processing unit, which lacks the ability to fulfil the safety and reliability requirements of CENELEC Standards EN 50126 - 50129 and hence cannot be certified as being safe. While the risk of instability is reduced by the installation of such devices, it cannot be brought down to 0, since an undetected malfunction of the monitoring device during unstable run is still possible.

Distributed safety monitoring systems based on local monitoring units interconnected via a safety loop are known in the art. Examples of the use of such systems in rail vehicles are known for monitoring the closing of doors, the actuation of brakes or the uncoupling of coaches.

GB 1 345 955 provides a control circuit arrangement extending through the length of the train and which serves, in accordance with the requirements of safe railway operation, for remotely controlling and monitoring uncoupling operations, for remotely controlling the brake control devices of the coaches, and for self-monitoring its operation and insulation. It comprises, in the traction unit of the train, a central switch-off mechanism operatively connected to an insulation monitor which, in turn, is connected to an alarm operative to indicate breakdown of or fault in the circuit arrangement, the alarm also being connected to a condition monitor for the switch-off mechanism, which condition monitor serves to sense whether or not the manner in which the train is operated corresponds to the setting of the central switch-off mechanism, an uncoupling impulse transmitter and a brake impulse transmitter each being connected respectively with the condition monitor and the switch-off mechanism, and a power source and a deadman handle each being connected respectively with the switch-off mechanism. The central switch-off mechanism includes a sensing device connected with a safety loop which extends through all of the coaches and which is adapted to provide a control circuit through all of the coaches whereby the completeness of the train can be monitored.

DE10026836C1 discloses a safety circuit arrangement extending through the length of a train. The safety loop monitoring device uses a constant current source for testing breaker contacts within the safety loop, connected in series with actuators, prior to operation. At least two current sensors located at different positions in the safety loop are used in the test procedure. The actuators are tested sequentially, and the test time unduly increases with the number of actuators and the size of the train.

Hence, there is still a need for a safety monitoring system which prevents undetected malfunction of the monitoring system itself and does not unduly prolong the startup procedure.

### SUMMARY OF THE INVENTION

The foregoing shortcomings of the prior art are addressed by the present invention. According to one aspect of the invention, there is provided a safety monitoring device for a rail vehicle, comprising:
- a sensor for delivering a safety-related signal,
- at least a first safety relay, having two main terminals and a control terminal for closing and opening an electrical connection between the main terminals,
- at least a first test circuit comprising:
   - a test power supply,
   - a test current detecting device,
   - first test switch means for switching the safety monitoring device between the operational mode and a first test mode, such that in the first test mode the main terminals of the first safety relay are connected between the test power supply and the current detecting device while in the operational mode the main terminals of the first safety relay are disconnected from the test power supply, and
- a control device connected to the sensor, to the control terminal of the first safety relay, to first test switch means and to the test current detecting device, the control device comprising:
   - means for controlling the switching of the safety monitoring device between the first test mode and the operational mode, and
   - means for monitoring the safety-related signal and for opening or closing the first safety relay depending on the safety-related signal in the operational mode of the safety monitoring device.

The main terminals of the safety relay can be connected to a safety loop which, in the operational mode at least, is connected to an external power source and to a detector for detecting the opening and closing of the safety relay. The first test circuit provides means for testing the first safety relay locally in the first test mode. Hence, in a safety loop comprising a plurality of such safety monitoring devices, all the safety relays can be simultaneously tested, which substantially decreases the testing time.

According to a preferred embodiment, the control device further comprises means for opening and closing the first safety relay according to a predetermined switching sequence and issuing a test result depending on the response of the current detecting device during the switching sequence in the first test mode. The sequence can be a simple CLOSE-OPEN-CLOSE sequence, or a more sophisticated one if necessary.

If the safety monitoring device is to be used in a hard environment such on a bogie of a rail vehicle, the safety relay should preferably be a solid state relay, i.e. a relay without moving parts.

According to a preferred embodiment, the first test switch means include:
- an upstream test switch for closing and opening an upstream branch of the first test circuit between a positive terminal of the test power supply and a first of the main terminals of the safety relay; and
- a downstream test switch for closing and opening a downstream branch of the first test circuit between the second main terminal of the safety relay and a ground of the safety monitoring device connected to a negative terminal of the test power supply.

The test current detecting device may be located in the second branch of the circuit.

Advantageously, the test power supply is a DC power supply and the upstream branch of the first test circuit is provided with a diode for preventing any flow of current towards the positive terminal of the test power supply.

The upstream and downstream test switches are preferably optocouplers, to keep the control device isolated from the test circuit. For the same reason, the test current detecting device and the first safety relay also include optocouplers.

To increase redundancy, the safety monitoring device may further comprise:
- a second safety relay, having two main terminals and a control terminal connected to the control device for closing and opening an electrical connection between the main terminals of the second safety relay, and
- a second test circuit comprising second test switch means connected to the control device for switching the safety monitoring device between a second test mode and the operational mode, such that in the second test mode the main terminals of the second safety relay are connected between the test power supply and the test current detecting device while in the operational mode the main terminals of the second safety relay are disconnected from the local test power supply.

According to a preferred embodiment, the opening of the first safety relay is triggered by the interruption of an AC control signal delivered by the control device while the opening of the second safety relay is triggered by the interruption of a DC control signal delivered by the control device.

Preferably, the current detecting device comprises a current detector connected to the first test circuit and to the second test circuit.

According to a further aspect of the invention, there is provided a distributed safety monitoring system comprising:
- a plurality of distributed safety monitoring devices as described hereinbefore,
- at least a first safety loop interconnecting the first safety relays of the plurality of safety monitoring devices in series via their main terminals,
- a common power supply connected to the first safety loop, and
- a common current detector connected to the safety loop for detecting the opening of at least one of the first safety relays of the plurality of distributed safety monitoring devices.

According to a further aspect of the invention, there is provided a distributed safety monitoring system comprising:
- a plurality of distributed safety monitoring devices with two safety relays,
- a first safety loop interconnecting the first safety relays of the plurality of safety monitoring devices in series via their main terminals,
- a second safety loop interconnecting the second safety relays of the plurality of safety monitoring devices in series via their main terminals,
- a common power supply for supplying the first and second safety loop, and
- a current detecting device for detecting the opening of at least one of the first and second safety relays of the plurality of distributed safety monitoring devices.

According to a preferred embodiment, the common power supply is isolated from the test power supplies of the distributed safety monitoring devices. Hence, there is no need to switch off the common power supply in the test mode.

Preferably, the opening of any one of the first safety relays corresponds to an interruption of current which is detected by the current sensor. In such a case, any failure of one safety monitoring device itself should also result in the opening of the corresponding safety relay. Hence, the first safety relays should preferably be open in the absence of control signal on the control terminal.

According to a further aspect of the invention, there is provided a rail vehicle provided with a plurality of bogies and with a safety monitoring system as described hereinbefore, wherein each bogie is provided with at least one of the safety monitoring devices of the safety monitoring system. The sensors used can be acceleration sensors or other types of safety-related sensors.

According to a further aspect of the invention, there is provided a method of testing a safety monitoring system as disclosed hereinbefore, wherein the first test circuits of the plurality of distributed safety monitoring devices are simultaneously switched to the first test mode to carry out a first test. Hence, the time for carrying out the initial test is short and independent from the number of safety monitoring devices in the safety loop. If the safety monitoring system includes two safety loops, the method preferably comprises a first test wherein the first test circuits of the plurality of distributed safety monitoring devices are simultaneously switched to the test mode and a second, subsequent step wherein the second test circuits of the plurality of distributed safety monitoring devices are simultaneously switched to the second test mode. Simultaneous tests are also possible if the two safety loops are not in series.

### BRIEF DESCRIPTION OF THE DRAWINGS

Other advantages and features of the invention will become more clearly apparent from the following description of specific embodiments of the invention given as non-restrictive example only and represented in the accompanying drawings in which:
- figure 1 is a block diagram of an instability monitoring device according to the invention;
- figure 2 illustrates a couple of a self-testable micro-electromechanical accelerometers of in the instability monitoring device of figure 1;
- figure 3A to 3K illustrate the processing of acceleration signal by the instability monitoring device of figure 1;
- figure 4A illustrates test circuits used for testing safety solid-state relays of the instability monitoring device of figure 1;
- figure 4B illustrates a variant of figure 4A; and
- figure 5A illustrates an instability monitoring system including a plurality of instability monitoring devices of the type illustrated in figure 1;
- figure 5B illustrates a variant of figure 5A.

### DETAILED DESCRIPTION OF VARIOUS EMBODIMENTS

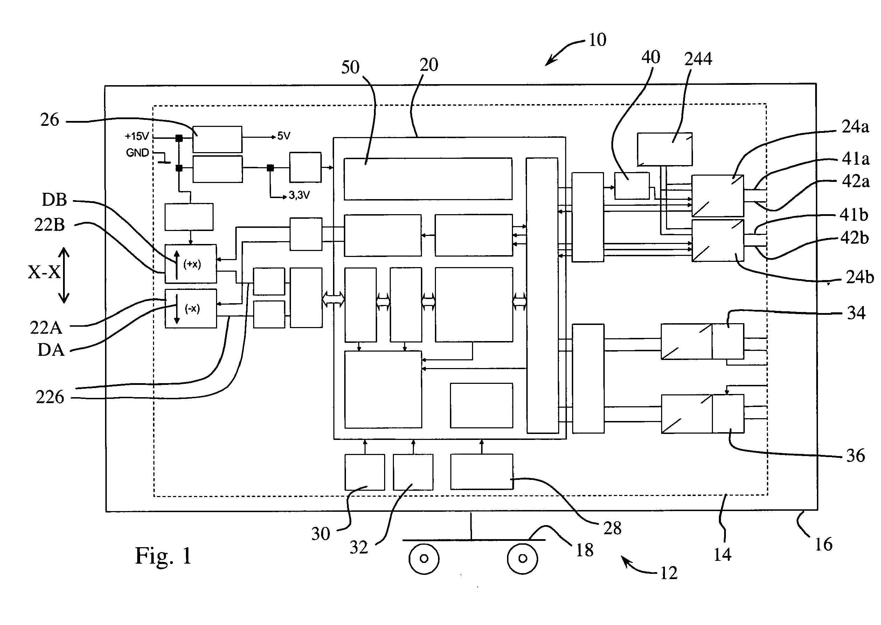

Referring to figure 1, an instability monitoring device 10 dedicated to the monitoring of the instability of a bogie 12 includes a printed circuit board 14 mounted in a box 16 fixed to a bogie frame 18. The circuit board 14 is built around a programmable logic device (PLD) 20 having two identical lateral accelerometers 22A, 22B as main inputs and two solid-state safety relays 24a, 24b as main outputs. The system is also equipped, besides the necessary power supply circuits 26, with a temperature sensor 28, a clock circuit 30, a watchdog circuit 32, an input for test demands 34 and outputs for indication of instability 36.

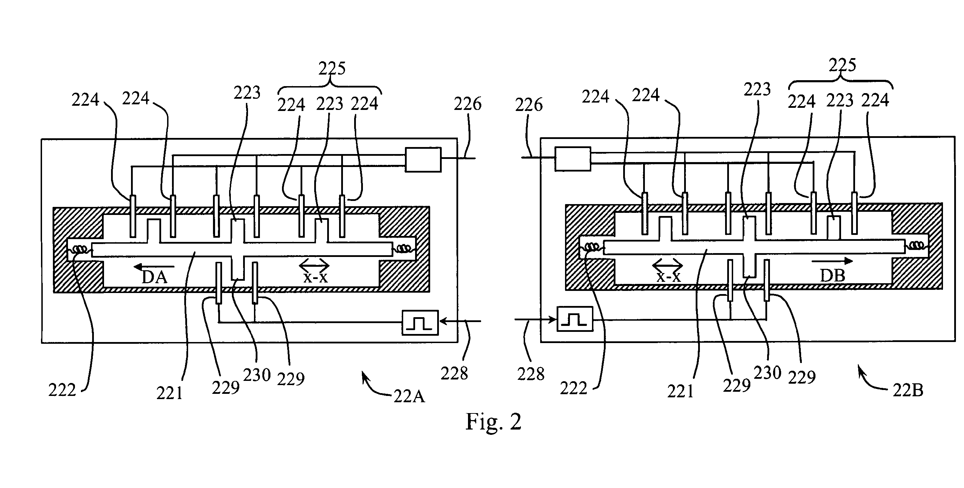

The two lateral acceleration sensors 22A, 22B, depicted in figure 2, are preferably of the MEMS (Micro-Electro-Mechanical System) type. This type of accelerometer is well-known in the art (e.g. reference SCA 1000 of VTI Technologies). The accelerometers 22A, 22B include an inertia mass in the form of a polysilicon beam 221 suspended over a substrate by supporting tethers 222. The beam 221, which is essentially parallel to the substrate, is elongated along a reference axis X-X, and provided with a number of plates 223 that extend away from the beam in a direction perpendicular to the axis of the beam. The beam and plates 223 are movable laterally relative to the substrate along the axis X-X. Each of these movable plates 223 is positioned between two polysilicon plates 224 that are perpendicular to the beam 221 and are fixed relative to the substrate. Each movable plate 223 and the fixed plates 224 on either side of the movable plate form a differential capacitor cell 225. The cells additively form a differential capacitor. Instead of polysilicon, the accelerometer may be made of other materials known in the art, such as monocrystalline silicon.

Different approaches can be used to sense acceleration with such a differential capacitor. The movable plates (i.e., movable with the mass) are each centred between two fixed plates in a rest position. All the fixed plates on one side of the movable plates are electrically coupled together and charged, and all the fixed plates on the other side of the movable plates are also electrically coupled together and charged. In response to an external force/acceleration along the reference axis, the mass with movable plates moves toward one or the other set of fixed plates, thus changing the capacitance between the different plates, which produces an electrical signal. This signal on the fixed plates is amplified, processed and provided to an output terminal 226.

To verify proper operation of the sensors 22A, 22B, a self-test input terminal 228 is provided. Activating self-test causes a step function force to be applied to the accelerometer 22 in a testable direction DA, DB parallel to the reference axis X-X. More specifically, activating the self-test via the self-test input terminal 228 causes the voltage on at least a pair of the fixed plates 229 on one side of the moving beam 221 in a test cell 231 to change. This creates an attractive electrostatic force on a test plate 230 integral with the movable beam 221, causing the beam 221 to move from the rest position toward in a testable direction. This sensor displacement in the testable direction changes the signal seen at the sensor output terminal 226.

Remarkably, the two identical accelerometers 22A, 22B are oriented in opposite directions on the printed circuit board, which means that their output have identical absolute instantaneous values and opposite signs when the printed circuit board is subjected to vibration. This also means that their reference axes X-X are aligned and that their testable directions DA, DB are opposite to one another.

The accelerometers 22A, 22B are connected to the programmable logic device PLD via an analog to digital converter A/DC. The programmable logic device can be a field-programmable gate array (FPGA) or a complex programmable logic device (CPLD). It is provided with non-volatile logic blocks running simultaneously in parallel and implementing an instability monitoring algorithm to change the state of the first and second solid-state relays from an active state to a fault state whenever an instability condition is detected.

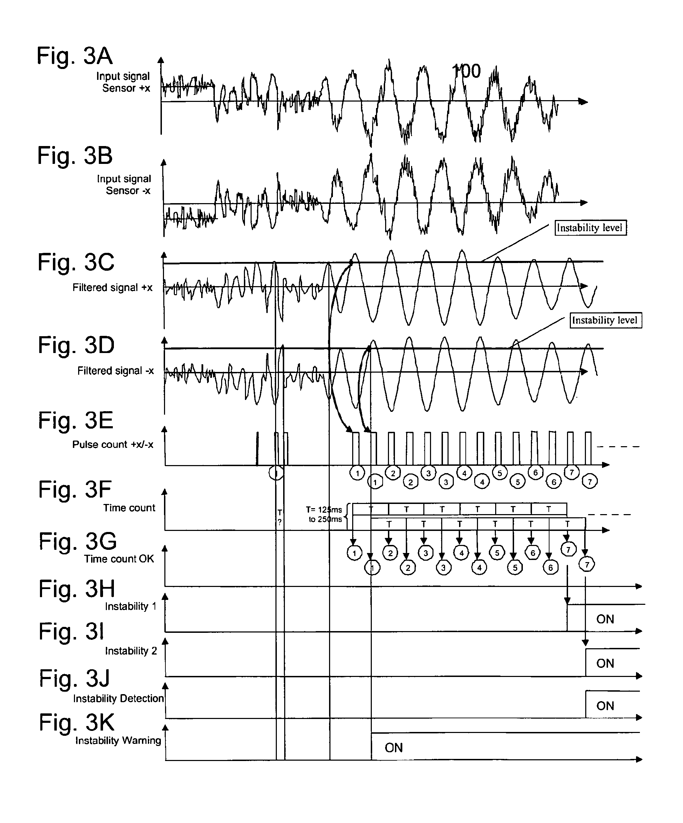

The digitalised acceleration signals from the first and second accelerometers, illustrated in figure 3A and 3B, respectively, are processed in parallel channels as depicted in figures 3C to 3K. When entering the programmable logic device, the digitalised acceleration signal of each accelerometer is first filtered using numerical band-pass filters. The band-pass filter consists of a low-pass and a high-pass second order Butterworth filters. The high-pass filter is used to eliminate signal offset. Its cutoff frequency (the -3dB frequency) is 3Hz. The low-pass filter has a cutoff frequency between 30 and 40 Hz to eliminate noise. The resulting filtered signals are shown in figure 3C and 3D. Peaks of the filtered signals above a predetermined threshold are detected as illustrated in figure 3E. The threshold is set for each accelerometer 22A, 22B in the direction corresponding to the corresponding testable direction DA, DB (i.e. a positive threshold in this example). Peaks of each acceleration signal in the direction opposite to the testable direction are not taken into account. Starting from zero, a counter is incremented for each accelerometer when consecutive peaks are detected within a predetermined time window, e.g. when two consecutive peaks are distant from one another by more than 125 ms and less than 250 ms, as illustrated in figure 3F. More precisely, a timer is started after each incrementation of the counter. If the time between the last counted peak and the new peak (measured by the timer) is less than 120 ms or more than 250 ms but less than 500 ms, the counter is not updated. The counter and the timer are reset to 0 if no peak has been detected during a period T=500 ms after the last peak or if peaks less than 125ms or more than 250ms apart are detected after the period of 500ms. An instability signal is delivered whenever the counter reaches N for one accelerometer as illustrated in figure 3H and 3I, in which case the timer and counter are also reset. An instability detection signal is delivered when an instability signal is detected for both accelerometers, as illustrated in figure 3J. A warning signal can also be delivered at an earlier stage, e.g. as soon as the first or second peak is detected on both channels, as illustrated in figure 3K. Remarkably, the algorithm used for detecting instabilities uses only one part of each acceleration signal, namely the part that corresponds to the testable direction of each accelerometer.

Each safety solid-state relay 24a, 24b is provided with two output terminals 41 a, 42a, 41 b, 42b and is designed to change its state from an active state to a fault state upon change of the corresponding control signal on a control input terminal. The first and second solid-state relays 24a, 24b act as "normally open" contacts, which means that they are closed when energised and open in the absence of control signal. More specifically, an AC control signal of predetermined frequency (e.g. 1000 Hz) is supplied by the programmable logic device 20 to a frequency detector 40 connected to the first solid-state relay 24a in the absence of instability to maintain the first solid-state relay in its active, closed state. In the same circumstances, a DC control signal is supplied by the programmable logic device 20 to the second solid-state relay 24b to maintain it in the closed state. The detection of instability triggers the interruption of the two control signals and the opening of the two safety solid-state relays 24a, 24b.

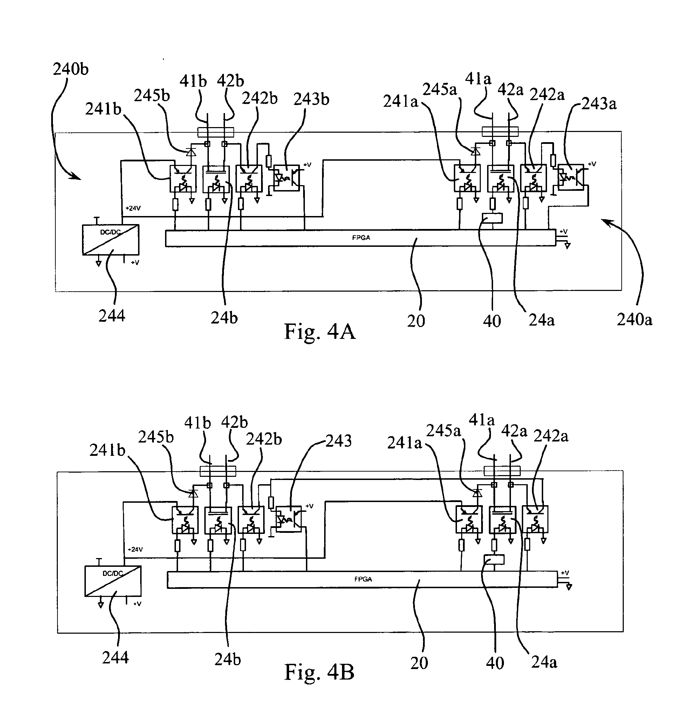

Referring to figure 4A, the solid-state relay 24a is provided with a local test circuit 240a including two test switches 241 a, 242a and a test current detector 243a. An upstream branch of the local test circuit 240a connects one of the test switches 241 a in series between one terminal 41 a of the solid-state relay and the positive terminal a local test DC power supply 244. A diode 245a can be provided in the upstream branch to prevent current backflow into the local test power supply. The downstream branch of the local test circuit connects the other output terminal 42a of the solid-state relay to the second test switch 242a and the latter to the test current detector 243a which is connected to the ground defined by the negative terminal of the local test power supply 244 to close the circuit. The current detector 243a is used to detect the presence of current through the terminals 41 a, 42a of the solid-state relay when the first and second test switches 241 a, 242a are closed as well as the solid-state relay. The second solid-state relay 24b is provided with a similar test circuit using the same power supply 244, and the corresponding parts have been designated in figure 4A with the same reference numbers, using a "b" as suffix instead of "a". As shown in the variant of figure 4B, a common current detector 243 can be used instead of two separate current detectors 243a and 243b.

The solid-state relays 24a, 24b, the pairs of test switches 241, 242 and the current detector 243 are connected to the programmable logic device 20 and are realised as optocouplers so that their connections to the programmable logic device 20 are fully isolated from their connections to the test circuit.

The programmable logic device 20 is also provided with a finite state machine 50 (see figure 1) for performing a series of tests for checking the operability of the instability monitoring device.

In a first test sequence, the switching of the solid-state relays is checked. The programmable logic device 20 closes the test switches 241, 242 of the first solid-state relay 24a and interrupts the AC control signal for a predetermined duration while the response of the first solid-state relay 24a is checked by the test current detector 243. If a current is detected by the test current detector 243 during the interruption of the AC control signal the test has failed and the state machine goes to the start-up fault state. Subsequently, the test is repeated for the second solid-state relay 24b, with the appropriate DC control signal being interrupted and switched back ON by the programmable logic device.

In a second test sequence, the internal test circuits of the accelerometers are used to simulate a test pattern that corresponds to an instability situation. A series of N voltage pulses is applied to the test terminals of the two accelerometers. The two accelerometers should then react with 80% of their full scale value and generate N peaks above the detection threshold. After N peaks, the instability monitoring algorithm should generate an instability signal and trigger the two solid-state switches. If no instability signal is generated, the test has failed and the state machine 50 goes to the start-up fault state.

Remarkably, the use of two accelerometers 22A, 22B oriented in opposite directions in each instability monitoring device makes it possible to selectively detect in the actual monitoring algorithm the peaks of each accelerometer signal that corresponds to movements of the inertia mass from the rest position in the testable direction, which has actually been tested. In other words, the peak threshold of the algorithm is set so that the peaks of the accelerometer signal in the direction opposite to the testable direction, i.e. the direction for which the internal test circuit of the accelerometer do not allow testing, are disregarded.

The instability monitoring devices may include other tests, e.g. temperature measurements. The temperature measured by a temperature sensor is compared with lower and upper limits (e.g. between -40 and 95 °C). If the temperature is not within the predefined window, an alarm is triggered.

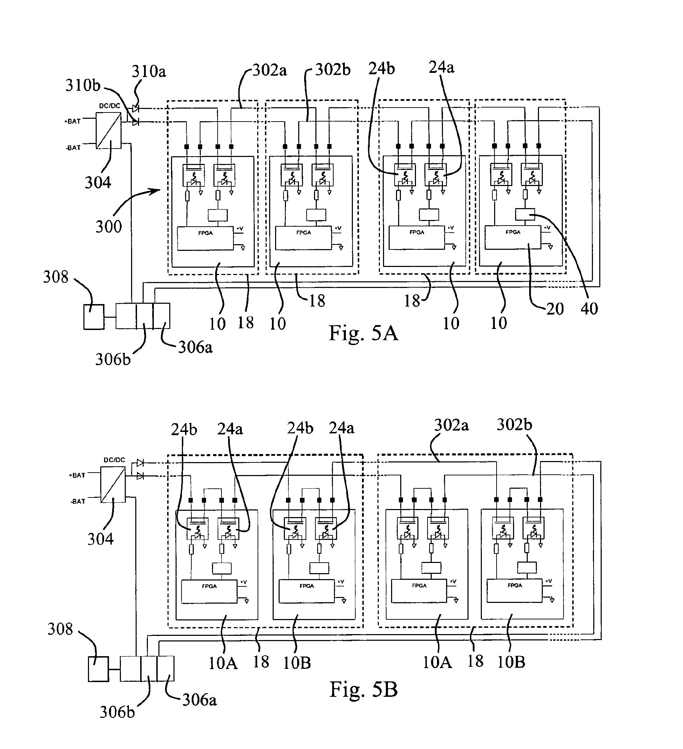

As illustrated in figure 5A, the instability monitoring device is duplicated on at least some of the bogie frames 18 of the rail vehicle, and preferably on all bogies, to build an instability monitoring system 300, which includes two safety loops 302a, 302b, one for connecting the first safety relays 24a of the instability monitoring devices 10 in series in a closed circuit including a DC power supply, e.g. a battery unit 304 and a common current detector 306a connected to an alarm 308 in the driver's cab, to a speed control system and/or to a brake control system of the vehicle, and the second one (302b) for connecting in the same conditions the second safety relays 24b of the instability monitoring devices 10 in series between the power supply 304 and a current detector 306b. Diodes 310a, 310b are also provided on the safety loops to prevent current backflow into the DC power supply 304.

Any interruption of the current detected a current detector 306a, 306b in the safety loop is considered as an instability event and results in appropriate action, e.g. operation of the alarm 308, decrease of the driving power and/or operation of the brakes of the rail vehicle.

The ground of each local test DC power supply 244 is isolated, so that the first test sequence referred to above can be carried out simultaneously on all first safety relays 24a, with superposition of the DC power of the safety loop 302a. However, the first and second safety relays of each unit should preferably be tested sequentially to avoid unreliable results, since it is envisaged that both safety loops are connected in series.

The instability monitoring system is provided with a test bus for performing controlling the start-up tests various tests on the distributed system to check its operability. The test bus is used to send test request to the instability monitoring device and gather the results.

To test the integrity of the safety loop cabling in a configured train, a special vehicle test can be executed. The instability monitoring devices of the last car shall be shutdown and powered again by means of the circuit-breaker of the rail car. This action will open and close the safety loop at this location and this will be verified in the driver's cab. If this test is positive it is considered that the whole safety loop is working. If not, the action shall be repeated on the instability monitoring device which is located directly upstream and this until the error is found. In such a case, the error in the cabling will be situated between the unit for which the loop is functioning and the next unit downstream.

As a variant, the two safety loops can be connected in series between a common power supply and a common current detector.

To limit availability problems in case of failure of one of the instability monitoring devices, it is also envisaged to provide each bogie with a first instability monitoring device 10A and a second instability monitoring device 10B, as illustrated in figure 5B. The safety relays 24a and 24b of each instability monitoring device are connected in series. The safety relays 24a, 24b of the first instability monitoring devices 10A are connected to a first safety loop 302A and the safety relays 24a, 24b of the second instability monitoring devices are connected to a second safety loop 302B. When one instability monitoring device is in failure and interrupts one of the safety loops, operation can be continued on the other safety loop.

The invention is not limited to the embodiments described hereinbefore.

If redundancy of the acceleration measurements is not critical, a single accelerometer can be used. Preferably, the single accelerometer should have two testable directions, i.e. it should be provided with test means for moving the inertia mass of the accelerometer on both sides of its rest position. The accelerometer or accelerometers can be biaxial or triaxial, in which case the signal from the additional axes can be simply disregarded or processed in parallel with the signal from the first axis. The signals from different axes can also be combined to build an acceleration vector, which will be processed by the programmable logic device. The accelerometers can be of any convenient type, e.g. based on piezoelectric transducers.

The instability monitoring algorithm can have many variants. In particular, the use of a time window with a lower and an upper threshold for counting the peaks can be replaced by more sophisticated numerical filters for disregarding the parts of the signal that are not in the observed frequency range.

Instead of processing the signals from the two accelerometers in parallel, the first part of the two signals can be combined to form a new acceleration signal.

If redundancy of the safety solid-state relays is not critical, one option is to eliminate one of the two solid-state relays, in which case the instability monitoring system will be provided with one safety loop only.

The instability monitoring system, which has been used in connection with a rail vehicle, can also be implemented in various complex systems in which distributed acceleration measurements are necessary to determine an instability condition, e.g. aircrafts or turbines of a power plant.

While the invention has been described in connection with an instability monitoring system, other safety-related variables can be monitored using the same type of monitoring device, e.g. the opening and closing of doors, the actuation of brakes or the uncoupling of coaches. More generally, similar safety monitoring devices and systems can be used for monitoring distributed safety-related physical variables in any kind of complex system.

## Claims

1. A safety monitoring device for a rail vehicle, comprising:
- a sensor for delivering a safety-related signal
- at least a first safety relay, having two main terminals and a control terminal for closing and opening an electrical connection between the main terminals,
- at least a first test circuit comprising:
- a test power supply,
- a test current detecting device,
- first test switch means for switching the safety monitoring device between the operational mode and a first test mode, such that in the first test mode the main terminals of the first safety relay are connected between the test power supply and the current detecting device while in the operational mode the main terminals of the first safety relay are disconnected from the test power supply, and
- a control device connected to the sensor, to the control terminal of the first safety relay, to first test switch means and to the test current detecting device, the control device comprising:
- means for controlling the switching of the safety monitoring device between the first test mode and the operational mode, and
- means for monitoring the safety-related signal and for opening or closing the first safety relay depending on the safety-related signal in the operational mode of the safety monitoring device.

2. The safety monitoring device of claim 1, wherein the control device further comprises means for opening and closing the first safety relay according to a predetermined switching sequence and issuing a test result depending on the response of the current detecting device during the switching sequence in the first test mode.

3. The safety monitoring device of any of the preceding claims, wherein the safety relay is a solid state relay.

4. The safety monitoring device of any one of the preceding claims, wherein the first test switch means include:
- an upstream test switch for closing and opening an upstream branch of the first test circuit between a positive terminal of the test power supply and a first of the main terminals of the safety relay; and
- a downstream test switch for closing and opening a downstream branch of the first test circuit between the second main terminal of the safety relay and a ground of the safety monitoring device connected to a negative terminal of the test power supply.

5. The safety monitoring device of claim 4, wherein the test current detecting device is located in the second branch of the circuit.

6. The safety monitoring device of claim 4 or claim 5, wherein the test power supply is a DC power supply and the upstream branch of the first test circuit is provided with a diode for preventing any flow of current towards the positive terminal of the test power supply.

7. The safety monitoring device of any one of the preceding claims, wherein the first safety relay, first test switch means and test current detecting device include optocouplers, so as to keep the control device electrically isolated from the test circuit.

8. The safety monitoring device of any of the preceding claims, further comprising:
- a second safety relay, having two main terminals and a control terminal connected to the control device for closing and opening an electrical connection between the main terminals of the second safety relay, and
- a second test circuit comprising second test switch means connected to the control device for switching the safety monitoring device between a second test mode and the operational mode, such that in the second test mode the main terminals of the second safety relay are connected between the test power supply and the test current detecting device while in the operational mode the main terminals of the second safety relay are disconnected from the local test power supply.

9. The safety monitoring device of claim 8, wherein the opening of the first safety relay is triggered by the interruption of an AC control signal delivered by the control device while the opening of the second safety relay is triggered by the interruption of a DC control signal delivered by the control device.

10. The safety monitoring device of claim 8 or claim 9, wherein the current detecting device comprises a current detector connected to the first test circuit and to the second test circuit.

11. A distributed safety monitoring system comprising:
- a plurality of distributed safety monitoring devices according to any one of the preceding claims,
- at least a first safety loop interconnecting the first safety relays of the plurality of safety monitoring devices in series via their main terminals,
- a common power supply connected to the first safety loop, and
- a common current detector connected to the safety loop for detecting the opening of at least one of the first safety relays of the plurality of distributed safety monitoring devices.

12. A distributed safety monitoring system comprising:
- a plurality of distributed safety monitoring devices according to any one of claims 8 to 10,
- a first safety loop interconnecting the first safety relays of the plurality of safety monitoring devices in series via their main terminals,
- a second safety loop interconnecting the second safety relays of the plurality of safety monitoring devices in series via their main terminals,
- a common power supply for supplying the first and second safety loop, and
- a current detecting device for detecting the opening of at least one of the first and second safety relays of the plurality of distributed safety monitoring devices.

13. The distributed safety monitoring system of claim 11 or claim 12, wherein the common power supply is isolated from the test power supplies of the distributed safety monitoring devices.

14. The distributed safety monitoring system of any of any one of claims 11 to 13, wherein the first safety relays are open in the absence of a control signal on the control terminal.

15. A rail vehicle provided with a plurality of bogies and with a safety monitoring system according to any one of claims 12 to 14, wherein each bogie is provided with at least one of the safety monitoring devices of the safety monitoring system.

16. A method of testing a safety monitoring system according to any one of claims 11 to 14, wherein the first test circuits of the plurality of distributed safety monitoring devices are simultaneously switched to the first test mode to carry out a first test.

17. A method for testing a safety monitoring system according to any one of claims 12 to 14, comprising a first test wherein the first test circuits of the plurality of distributed safety monitoring devices are simultaneously switched to the test mode and a second, subsequent step wherein the second test circuits of the plurality of distributed safety monitoring devices are simultaneously switched to the second test mode.
